# EUROPEAN PATENT APPLICATION

(11) **EP 2 423 972 A1**
(43) Date of publication of application: **29.02.2012**
(21) Application number: 10766915.2
(22) Date of filing: 15.03.2010
(51) Int. Cl.: H01L 31/042

(54) **SOLAR CELL MODULE AND METHOD FOR MANUFACTURING SOLAR CELL MODULE**

(30) Priority: 20.04.2009 JP 2009102276
(71) Applicant: Sharp Kabushiki Kaisha, Osaka-shi, Osaka 545-8522 (JP)
(72) Inventor: KOBAYASHI, Masakazu, Osaki-shi, Osaka 545-8522 (JP)
(74) Representative: Müller-Boré & Partner Patentanwälte
(86) International application number: PCT/JP2010/054298
(87) International publication number: WO 2010/122856

(57) **Abstract**

A solar battery module (1) serving includes a first plate-like member (11) having translucency and serving as a light receiving face, a second plate-like member (12) having translucency, a solar battery (13), and a translucent sealing resin portion (14) provided for sealing the solar battery (13) between the first plate-like member (11) and the second plate-like member (12). The second plate-like member (12) has a lead-wire lead-out hole (12h) through which a lead wire (17) connected to the solar battery (13) is led out, and the translucent sealing resin portion (14) is formed extending between the lead wire (17) and the lead-wire lead-out hole (12h).

## Description

### Technical Field

The present invention relates to a solar battery module that includes a first plate-like member having translucency, a second plate-like member having translucency, and a solar battery, and to a method for manufacturing such a solar battery module.

### Background Art

Solar battery modules have various types of structures depending on their application, usage environment, and the like. One example of such solar battery modules is that having a laminated glass structure (see Patent Document 1, for example). A solar battery module having a laminated glass structure is configured such that a solar battery cell array constituted by multiple solar battery cells that are electrically connected to one another is sandwiched between a front-face-side plate glass and a back-face-side plate glass and thereby sealed within the module.

With a solar battery module having a laminated glass structure, sunlight that enters the solar battery module through the front-face-side plate glass passes through a translucent sealing resin in portions where solar battery cells do not exist, and reaches the back-face-side plate glass. The sunlight reaching the back-face-side plate glass is transmitted through the back-face-side plate glass to the outside of the solar battery module. Accordingly, the solar battery module with a laminated glass structure allows sunlight to be received even in the space located on the back face side of the solar battery module, and so it can be suitably used as a so-called daylighting-type solar battery module.

The solar battery module with a laminated glass structure employs a back-face-side plate glass, instead of a back-face-side back film of a solar battery module having an assembly structure, generally called a super straight structure. In the solar battery module having a laminated glass structure, tempered glass is used for the front-face-side plate glass and the back-face-side plate glass. The thickness of the plate glass is designed to withstand the required wind load. As a result, it is possible to install the solar battery module in various architectural structures such as windows or skylights of houses, buildings or the like, sound insulation walls along roads, or arcades.

Examples of industrial solar battery modules having a laminated glass structure include those configured by laminating solar battery modules having a laminated glass structure in multiple layers via a spacer member made of aluminum. Such a multilayered solar battery module can also achieve the same daylighting effect as described above achieved by the daylighting-type solar battery module.

With a daylighting-type solar battery module having a laminated glass structure disclosed in Patent Document 1, copper foil serving as internal wiring is extended to edge portions, and copper foil and output cables are connected in the edge portions. Accordingly, terminal boxes (junction boxes) for protecting connected portions between output cables and internal wiring are arranged in peripheral edge portions of a translucent substrate.

### Prior Art Document

### Patent Document

[Patent Document 1] JP 2001-339088A

### Summary of Invention

### Problem to be Solved by the Invention

When a daylighting-type solar battery module is installed, the solar battery module is ordinarily sandwiched in a sash frame made of aluminum, and so the terminal boxes attached to the edge portions of the solar battery module are housed within the sash frame, and the output cables are routed within the sash frame. Accordingly, it is necessary to set the width and thickness of the sash frame in correspondence with the terminal boxes, which results in an increased size of the sash frame, makes it difficult to integrate the sash frame with the solar battery module, and further causes problems such as poor installability, a reduction in the area ratio of the light receiving face to the sash frame, and deterioration in external appearance.

In today's environment where a high level of design is in particular considered preferable, a solar battery module is installed by applying a gasket material to the four sides, but it is difficult to apply a gasket material in the case of a solar battery module in which terminal boxes or diode boxes are arranged in the edge portions of the solar battery module.

The present invention has been conceived in light of these circumstances, and an object of the present invention is to provide a daylighting-type solar battery module that eliminates the need to arrange lead wires and terminal boxes in edge portions of the solar battery module by providing a second plate-like member with a lead-wire lead-out hole through which a lead wire from a solar battery is led out and forming a translucent sealing resin portion between a lead wire and a lead-wire lead-out hole, and that has compatibility with a construction method that requires the module to have shaped edge portions at the time of installation by shaping the edge portions of the solar battery module to be plate-like.

### Means for Solving the Problems

Problem solving means of the present invention for achieving the above-described object is based on a solar battery module that includes a first plate-like member having translucency and serving as a light receiving face, a second plate-like member having translucency, a solar battery, and a translucent sealing resin portion provided for sealing the solar battery between the first plate-like member and the second plate-like member. With this solar battery module, the second plate-like member is provided with a lead-wire lead-out hole through which a lead wire connected to the solar battery is led out, and the translucent sealing resin portion is formed extending between the lead wire and the lead-wire lead-out hole.

With this configuration, the lead wire can be led out of the second plate-like member serving as a non-light-receiving face through the lead-wire lead-out hole. This eliminates the need to arrange lead wires and terminal boxes in edge portions of the first plate-like member and the second plate-like member (edge portions of the solar battery module). As a result, the edge portions of the first plate-like member and the second plate-like member (the edge portions of the solar battery module) can be shaped to be plate-like, and therefore, the daylighting-type solar battery module can have compatibility with a construction method that requires the module to have shaped edge portions at the time of installation.

Furthermore, in the solar battery module according to the present invention, the first plate-like member and the second plate-like member are made of glass.

This configuration allows the solar battery module to apply the second plate-like member and the second plate-like member that ensure high translucency, high reliability, and high productivity.

Furthermore, in the solar battery module according to the present invention, the lead-wire lead-out hole has a chamfered portion or a countersunk portion in an edge portion.

This configuration improves the mechanical strength of the edge portion of the lead-wire lead-out hole, prevents the lead-wire lead-out hole from being damaged, and improves the mechanical strength of the second plate-like member, thus making a solar battery module having high productivity and reliability. The configuration further prevents the lead-wire lead-out hole from damaging the lead wire.

Furthermore, in the solar battery module according to the present invention, the chamfered portion or the countersunk portion is formed on both sides of the second plate-like member.

This configuration further improves the mechanical strength of the edge portion of the lead-wire lead-out hole and further improves the mechanical strength of the second plate-like member, thus making a solar battery module having higher productivity and reliability.

Furthermore, in the solar battery module according to the present invention, the translucent sealing resin portion formed in the lead-wire lead-out hole is in the same plane as or projects from a surface of the second plate-like member.

With this configuration, the lead-wire lead-out hole can be sealed with reliability and the lead wire can be separated with reliability from the wall of the lead-wire lead-out hole, thus making a solar battery module having high reliability.

Furthermore, the solar battery module according to the present invention includes a terminal box having a bottom face with an opening formed corresponding to the lead-wire lead-out hole, the bottom face adhering to the second plate-like member.

With this configuration, it is possible to block the lead-wire lead-out hole from the outside, preventing moisture from entering inside the solar battery module from the outside through the lead-wire lead-out hole and accordingly improving reliability.

Furthermore, in the solar battery module according to the present invention, the opening has a projecting portion that is aligned with the lead-wire lead-out hole.

This configuration allows the terminal box to be aligned with the lead-wire lead-out hole with ease and high precision, thus making a solar battery module having high productivity.

Furthermore, in the solar battery module according to the present invention, the opening has a slit shape corresponding to the lead wire.

This configuration makes it possible to reduce a gap around the lead wire that is led out through the lead-wire lead-out hole and position the lead wire with high precision, and to suppress the entry of moisture from the outside to the inside of the solar battery module, thus improving productivity and reliability.

Furthermore, in the solar battery module according to the present invention, the lead wire is bent at a portion where the lead wire is led out of the lead-wire lead-out hole.

This configuration enables connection between the lead wire and a cable terminal of a connection cable to be facilitated.

A method for manufacturing the solar battery module according to the aforementioned problem-solving means also falls within the technical idea of the present invention. That is, the problem-solving means is also based on a method for manufacturing a solar battery module that includes a solar battery, a first plate-like member having translucency and serving as a light receiving face, a second plate-like member having translucency, and a translucent sealing resin portion provided for sealing the solar battery between the first plate-like member and the second plate-like member. The method for manufacturing a solar battery module includes a lead-out-hole forming step of connecting a lead wire to the solar battery and forming a lead-wire lead-out hole in the second plate-like member, a lead-out step of leading the lead wire to the outside surface of the second plate-like member through the lead-wire lead-out hole, and a sealing step of forming the translucent sealing resin portion between the first plate-like member and the second plate-like member and sealing the solar battery.

With this method for manufacturing a solar battery module, the lead wire can be led to the outer face of the second plate-like member serving as a non-light-receiving face. This eliminates the need to arrange lead wires and terminal boxes in the edge portions of the first plate-like member and the second plate-like member, i.e., the edge portions of the solar battery module. Accordingly, the edge portions of the first plate-like member and the second plate-like member (the edge portions of the solar battery module) can be shaped to be plate-like, and therefore, it is possible to manufacture a daylighting-type solar battery module that has compatibility with a construction method that requires the module to have shaped edge portions at the time of installation.

Furthermore, in the method for manufacturing a solar battery module according to the present invention, an outflow-resin molding member having air permeability and heat resistance is arranged on the second plate-like member after the lead-out step so as to block the lead-wire lead-out hole through which the lead wire is led out.

This prevents a sealing resin of the translucent sealing resin portion from flowing out of the lead-wire lead-out hole in the sealing step. As a result, the elasticity of the lead wire is ensured and the lead wire can be suitably arranged without the lead wire adhering to the second plate-like member.

The outflow-resin molding member becomes unnecessary after the sealing step has been performed, and so it is preferable for the outflow-resin molding member to be removed from the second plate-like member after the sealing step.

Furthermore, the method for manufacturing a solar battery module according to the present invention includes a step of bending the led-out lead wire after the lead-out step so that the lead wire is arranged along the outer face of the second plate-like member, and a step of arranging an adhesion prevention member between the lead wire and the outer face of the second plate-like member, the adhesion preventing member preventing adhesion between a bent lead wire and the second plate-like member.

With the inclusion of these steps, the adhesion prevention member prevents adhesion between the lead wire and the second plate-like member, and therefore the elasticity of the lead wire is ensured and the lead wire can be suitably arranged.

The adhesion prevention member becomes unnecessary after the sealing step has been performed, and so it is preferable for the adhesion prevention member to be removed from the second plate-like member after the sealing step. A solar battery module with good external design is thereby manufactured.

### Effects of the Invention

The solar battery module according to the present invention includes a solar battery, a first plate-like member having translucency and serving as a light receiving face, a second plate-like member having translucency, and a translucent sealing resin portion provided between the first plate-like member and the second plate-like member and for sealing the solar battery. The second plate-like member is provided with a lead-wire lead-out hole through which a lead wire connected to the solar battery is led out, and the translucent sealing resin portion is formed extending between the lead wire and the lead-wire lead-out hole.

The method for manufacturing a solar battery module according to the present invention is a method for manufacturing a solar battery module that includes a solar battery, a first plate-like member having translucency and serving as a light receiving face, a second plate-like member having translucency, and a translucent sealing resin portion provided between the first plate-like member and the second plate-like member and for sealing the solar battery. The method includes a lead-out-hole forming step of connecting a lead wire to the solar battery and forming a lead-wire lead-out hole in the second plate-like member, a lead-out step of leading the lead wire to the outer face of the second plate-like member through the lead-wire lead-out hole, and a sealing step of forming the translucent sealing resin portion between the first plate-like member and the second plate-like member and sealing the solar battery.

With the present invention including these specific items, it is possible to lead the lead wire to the outside of the second plate-like member serving as a non-light-receiving face through the lead-wire lead-out hole. This eliminates the need to arrange lead wires and terminal boxes in edge portions of the solar battery module. Accordingly, the edge portions of the first plate-like member and the second plate-like member, i.e., the edge portions of the solar battery module, can be shaped to be plate-like, which brings about the effect of achieving a daylighting-type solar battery module that has compatibility with a construction method that requires the module to have shaped edge portions at the time of installation.

### Brief Description of Drawings

[FIG. 1] FIG. 1 is an exploded perspective view of a main portion of a solar battery module according to Embodiment 1 of the present invention.
[FIG. 2A] FIG. 2A is an enlarged sectional view of a main portion of a lead-wire lead-out hole before the main portion of the solar battery module shown in FIG. 1 (a translucent sealing resin portion of the lead-wire lead-out hole) is formed.
[FIG. 2B] FIG. 2B is an enlarged sectional view of the main portion of the lead-wire lead-out hole after the main portion of the solar battery module shown in FIG. 2A (the translucent sealing resin portion of the lead-wire lead-out hole) has been formed.
[FIG. 3] FIG. 3 is a plan view schematically illustrating a completed state of the solar battery module shown in FIG. 1.
[FIG. 4] FIG. 4 is a plan view schematically showing an example (Example 1-1) of a solar battery module manufactured by a method for manufacturing a solar battery module according to the present invention.
[FIG. 5] FIG. 5 is a plan view schematically showing another example (Example 1-2) of the solar battery module manufactured by the method for manufacturing a solar battery module according to the present invention.
[FIG. 6A] FIG. 6A is a partial cross-sectional view conceptually illustrating, in cross-section, a state in which a terminal box is arranged (Example 2·1) in a solar battery module according to Embodiment 2 of the present invention.
[FIG. 6B] FIG. 6B is a partial cross-sectional view conceptually illustrating, in cross-section, a state in which a terminal box is arranged (Example 2-2) in the solar battery module according to Embodiment 2 of the present invention.
[FIG. 6C] FIG. 6C is a partial cross-sectional view conceptually illustrating, in cross-section, a state in which a lead wire is arranged in a terminal box (Example 2-3) in the solar battery module according to Embodiment 2 of the present invention.
[FIG. 6D] FIG. 6D is a partial cross-sectional view conceptually illustrating, in cross-section, a state in which a lead wire is arranged in a terminal box (Example 2-4) in the solar battery module according to Embodiment 2 of the present invention.
[FIG. 6E] FIG .6E is a partial cross-sectional view conceptually illustrating, in cross-section, a state in which a lead wire is arranged in a terminal box (Example 2-5) in the solar battery module according to Embodiment 2 of the present invention.
[FIG. 7] FIG. 7 is a cross-sectional view conceptually illustrating, in cross-section, a gasket material and its surroundings in a gasket type solar battery module according to Embodiment 3 of the present invention.

### Mode for Carrying out the Invention

Hereinafter, embodiments of the present invention will be described with reference to the drawings.

### Embodiment 1

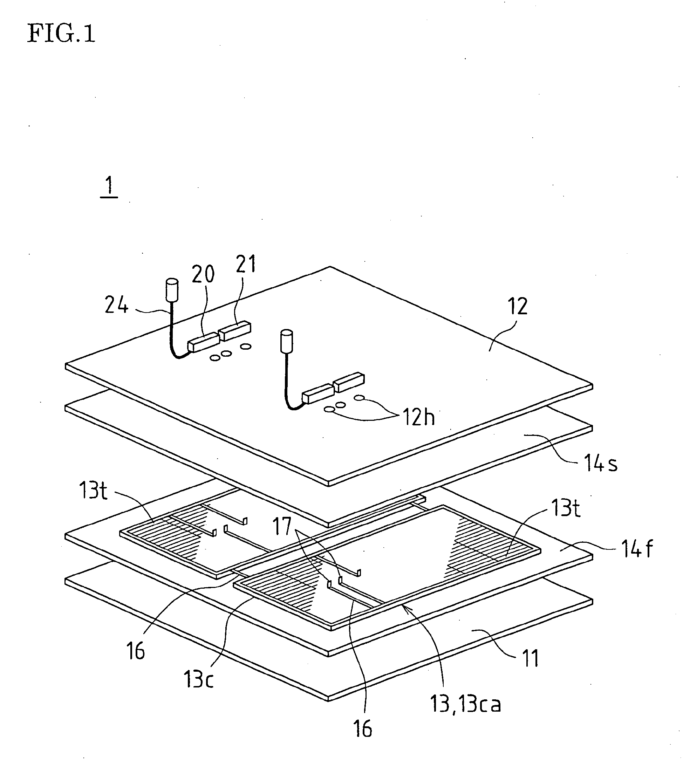

A solar battery module according to the present embodiment will be described with reference to FIGS. 1 to 3.

### Solar Battery Module

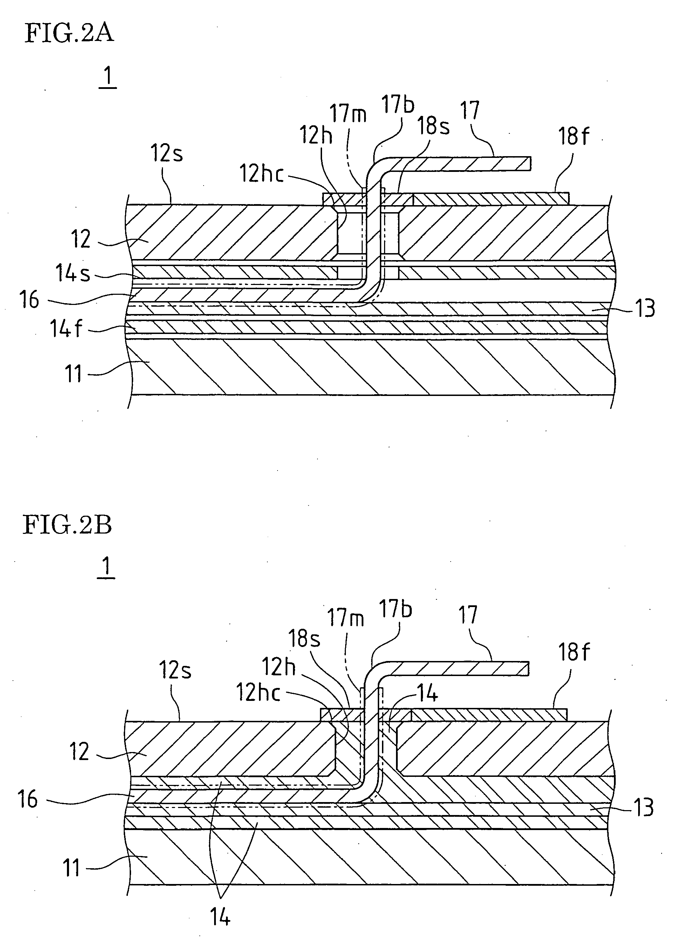

FIGS. 1 to 2B show a main portion of a solar battery module according to Embodiment 1. FIG. 1 is an exploded perspective view of the solar battery module. FIG. 2A is an enlarged sectional view of a main portion of a lead-wire lead-out hole before a translucent sealing resin portion of the lead-wire lead-out hole is formed in the solar battery module shown in FIG. 1. FIG. 2B is an enlarged sectional view of the main portion of the lead-wire lead-out hole after the translucent sealing resin portion of the lead-wire lead-out hole has been formed.

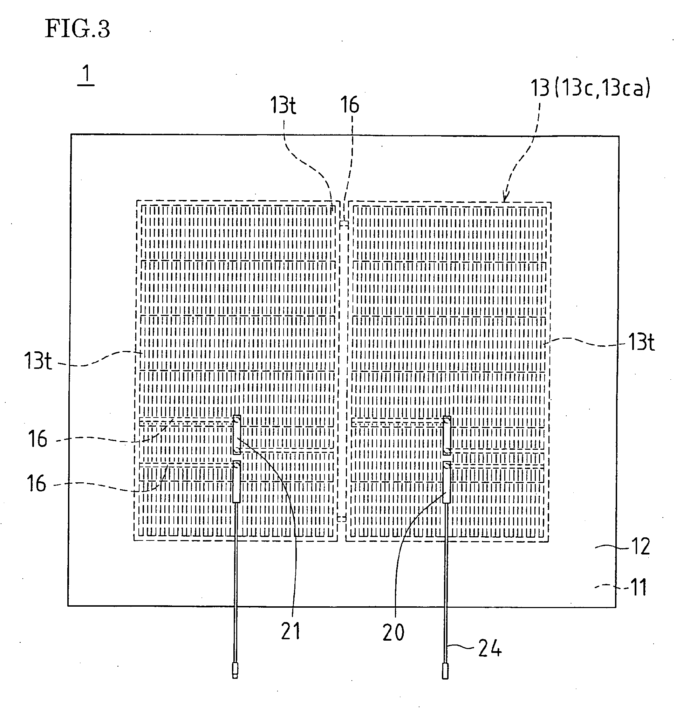

FIG. 3 is a schematic plan view conceptually illustrating a completed state of the solar battery module shown in FIG. 1. Note that a second plate-like member 12 has translucency and so the structures of a solar battery 13 and internal connection wires 16 located inside are visible from the outside, with these structure being indicated herein by broken lines in order to show that they are housed inside the module.

The solar battery module 1 according to the present embodiment includes a first plate-like member 11 having translucency and serving as a light receiving face, the second plate-like member 12 having translucency, the solar battery 13, and a translucent sealing resin portion 14 provided between the first plate-like member 11 and the second plate-like member 12 and for sealing the solar battery 13.

In the solar battery module 1, the second plate-like member 12 is provided with lead-wire lead-out holes 12h through which lead wires 17 connected to the solar battery 13 are led out, and the translucent sealing resin portion 14 is formed extending between the lead wires 17 and the lead-wire lead-out holes 12h.

Accordingly, the lead wires 17 can be led to the outside of the second plate-like member 12, which serves as a non-light-receiving face, through the lead-wire lead-out holes 12h. This eliminates the need to arrange the lead wires 17 and terminal boxes 20 in edge portions of the first plate-like member 11 and the second plate-like member 12 (edge portions of the solar battery module 1). The edge portions of the first plate-like member 11 and the second plate-like member 12 (the edge portions of the solar battery module 1) can thus be shaped to be plate-like, and therefore, the daylighting-type solar battery module 1 can have compatibility with a construction method that requires the module to have shaped edge portions at the time of installation.

Note that the lead wires 17 may be coated lead wires whose surfaces are coated with an insulating coating material 17m or may be bare lead wires that are not coated with the insulating coating material 17m. By coating the lead wires with the insulating coating material 17m, it is possible to prevent the lead-wire lead-out holes 12h from affecting the lead wires 17 (such as the occurrence of abrasion) and thereby to obtain highly reliable lead wires 17. Preferable examples of the insulating coating material 17m include PET and glass fiber in consideration of insulating properties, heat resistance, and the like.

In the solar battery module 1, the first plate-like member 11 and the second plate-like member 12 are made of glass. Accordingly, the daylighting-type solar battery module 1 can apply the second plate-like member 12 and the second plate-like member 12 that ensure high translucency, high reliability, and high productivity. That is, the daylighting-type solar battery module 1 has a laminated glass structure in which the solar battery 13 (solar battery cell array 13ca) is sealed via the translucent sealing resin portion 14 inside the first plate-like member 11 and the second plate-like member 12 that are arranged facing each other.

Note that the first plate-like member 11 and the second plate-like member 12, when made of glass, may, for example, be rectangular in shape having dimensions of approximately 1 m by 1 m and a thickness of approximately 5 to 10 mm. Alternatively, a translucent substrate other than glass may be appropriately selected and used for the first plate-like member 11 and the second plate-like member 12.

The translucent sealing resin portion 14 is in close contact with the first plate-like member 11, the second plate-like member 12, and the solar battery 13. The translucent sealing resin portion 14 needs to be made of a material that is not likely to damage solar battery cells 13c in a lamination step described later, and it is also preferable from the viewpoint of weather resistance to use a material having the property of being less susceptible to deterioration even if it is subjected to high-temperature and high-humidity environments for a long period of time.

Accordingly, examples of the material applicable as the translucent sealing resin portion 14 include resin materials such as ethylene-vinyl acetate copolymer (EVA) resins, polyvinyl butyral (PVB) resins, and silicone resins.

This translucent sealing resin portion 14 is a packed bed that is formed by thermally melting a first laminated pressure-bonded resin film 14f and a second laminated pressure-bonded resin film 14s and causing a crosslinking reaction between these resin films in the lamination step (sealing step). Note that in the exploded state shown in FIG. 1, the first laminated pressure-bonded resin film 14f and the second laminated pressure-bonded resin film 14s are shown individually as part of a laminate, but they are integrated and formed into the translucent sealing resin portion 14 (FIG. 2B) after the lamination step has been performed.

Accordingly, a solar battery cell array 13ca is arranged inside the translucent sealing resin portion 14 located between the first plate-like member 11 and the second plate-like member 12. In other words, the solar battery cell array 13ca is hermetically sealed with the translucent sealing resin portion 14. The solar battery cell array 13ca is configured by multiple solar battery cells 13c arranged in an array and internal connection wires 16 made of a conductor material, such as a metal wire, that provide electrical connections between the solar battery cells 13c.

The lead-wire lead-out holes 12h each have a chamfered portion 12hc or a countersunk portion (not shown) in edge portions of the hole. This improves the mechanical strength of the edge portions of the lead-wire lead-out holes 12h, prevents the lead-wire lead-out holes 12h from being damaged, and improves the mechanical strength of the second plate-like member 12, thus making a solar battery module 1 having high productivity and reliability.

The lead wires 17 are extensions of the internal connection wires 16 connected to the solar battery 13. The chamfered portions 12hc or the countersunk portions also act to prevent the lead-wire lead-out holes 12h from damaging the lead wires 17.

The chamfered portions 12hc or the countersunk portions further act to improve fluidity (filling property) of the translucent sealing resin portion 14 to the lead-wire lead-out holes 12h when the translucent sealing resin portion 14 is formed. Thus, the translucent sealing resin portion 14 formed extending into the lead-wire lead-out holes 12h is formed with reliability. Note that the chamfered portions 12hc with a width of, for example, approximately 0.5 mm will achieve a sufficient effect.

Also, it is preferable for the chamfered portions 12hc or the countersunk portions to be formed on both sides of the second plate-like member 12. This further improves the mechanical strength of the edge portions of the lead-wire lead-out holes 12h and further improves the mechanical strength of the second plate-like member 12, thus making a solar battery module 1 having higher productivity and reliability. In addition, since the fluidity of the translucent sealing resin portion 14 to the lead-wire lead-out holes 12h is further improved, it is possible to form the translucent sealing resin portion 14 with reliability in the lead-wire lead-out holes 12h.

It is preferable for the translucent sealing resin portion 14 formed extending into the lead-wire lead-out holes 12h to be in the same plane as or project from an outer face 12s of the second plate-like member 12. With this configuration, the lead-wire lead-out holes 12h can be sealed with reliability and the lead wires 17 can be separated from the walls of the lead-wire lead-out holes 12h with reliability. Accordingly, the solar battery module 1 is made highly reliable.

Note that the translucent sealing resin portion 14 can flow out of the lead-wire lead-out holes 12h and beyond the surface of the second plate-like member 12, when the translucent sealing resin portion 14 is formed by welding (press-bonding) the first laminated pressure-bonded resin film 14f and the second laminated pressure-bonded resin film 14s (solar-battery laminate forming and sealing step/lamination step/pressure bonding step).

It is thus preferable to block the lead-wire lead-out holes 12h with an outflow-resin molding member 18s that has air permeability and heat resistance (e.g., a breathable fluorine-based resin film, or heat-resistant cotton). This prevents the translucent sealing resin portion 14 from flowing to the outside from the outer face 12s of the second plate-like member 12. It is also possible, by blocking the lead-wire lead-out holes 12h with the outflow-resin molding member 18s, to cause the exposed surface of the translucent sealing resin portion to be in the same plane as or project slightly from the outer face 12s of the second plate-like member 12.

It is also preferable to arrange an adhesion prevention member 18f (e.g., a fluorine-based resin film) in correspondence with the lead wires 17 extended from bent portions 17b in a direction of extension of the outflow-resin molding member 18s. Arranging the adhesion prevention member 18f corresponding to the lead wires 17 prevents the lead wires 17 from adhering to the second plate-like member 12 even if the translucent sealing resin portion 14 leaks outside the outflow-resin molding member 18s, and thereby ensures the elasticity of the lead wires 17.

A configuration is also possible in which the adhesion prevention member 18f is also used in the region where the outflow-resin molding member 18s is to be arranged. That is, a configuration is also possible in which only the adhesion prevention member 18f is used in these regions. However, it is more preferable to use both the adhesion prevention member 18f and the outflow-resin molding member 18s in combination in order to improve formability.

The internal connection wires 16 are bent in the vicinity of the lead-wire lead-out holes 12h, extended along the shape of the lead-wire lead-out holes 12h, and led out as the lead wires 17. Accordingly, it is possible to reduce the diameter of the lead-wire lead-out holes 12h as much as possible and to maintain the strength of the second plate-like member 12 even if the lead-wire lead-out holes 12h are formed.

The lead wires 17 are bent at a portion (position) where they are led out of the lead-wire lead-out holes 12h, and so have a bent portion 17b, for example. Accordingly, connection between the lead wires 17 and connection cables 24 can be easily provided. For example, the lead wires 17 are bent at the bent portions 17b that are spaced from the outer face 12s of the second plate-like member 12. By spacing the bent portions 17b from the lead-wire lead-out holes 12h, the lead-wire lead-out holes 12h can be easily blocked with excellent workability and reliability.

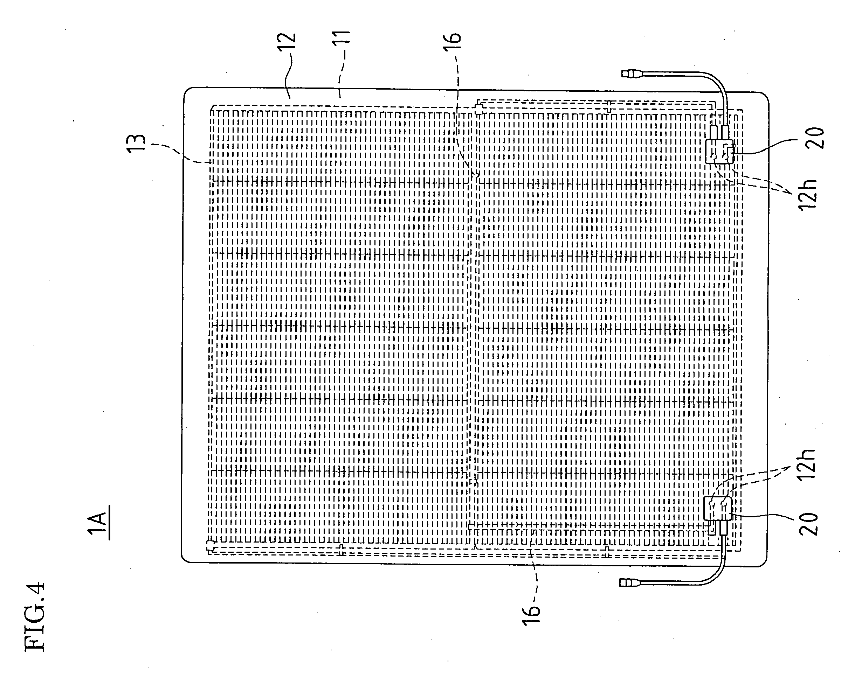

Also, the provision of the bent portions 17b makes it easy to connect the lead wires 17 to the connection cables 24 located outside. It is preferable for the bent portions 17b to have, for example, approximately the same height as cable terminals 24t (see FIGS. 4A and 4B) that are fixed to the inside of the terminal boxes 20 or diode boxes 21.

Alternatively, the cable terminals 24t may have fitting portions that are fitted to the tips of the lead wires 17.

As described above, the adhesion prevention member 18f prevents the lead wires 17 extending from the bent portions 17b along the surface of the second plate-like member 12 from adhering to the second plate-like member 12 with any resin that has leaked from the translucent sealing resin portion 14. Accordingly, it is possible to freely handle the lead wires 17 when connected to the connection cables 24.

The outflow-resin molding member 18s has air permeability and heat resistance. By the action of the outflow-resin molding member 18s, the translucent sealing resin portion 14 is formed in the same plane as or projecting from the outer face 12s of the second plate-like member 12. The translucent sealing resin portion 14 is thereby formed with high precision.

Note that the adhesion prevention member 18f and the outflow-resin molding member 18s may be removed after the translucent sealing resin portion 14 has been formed.

The lead wires 17 are connected to the connection cables 24 located outside and covered and protected by the terminal boxes 20. The diode boxes 21 that provide connection between by-pass diodes (not shown) connected to the solar battery 13 are also provided in the same manner and form as the terminal boxes 20. Lead wires 17 for connecting the by-pass diodes and the corresponding lead-wire lead-out holes 12h are formed in the same manner as the lead wires 17 in the terminal boxes 20 and the corresponding lead-wire lead-out holes 12h.

In FIG. 1, the lead-wire lead-out holes 12h and the lead wires 17 that correspond to the terminal boxes 20 and the lead-wire lead-out holes 12h and the lead wires 17 that correspond to the diode boxes 21 are shown. Note that the detailed structure of the terminal boxes 20 will be described later in Embodiment 2.

The solar battery 13 is a solar battery cell array 13ca configured by connecting multiple solar battery cells 13c. The solar battery cells 13c are electric-power generating elements configured by, for example, forming semiconductor junctions such as pn junctions in a crystal semiconducting material, or a thin-film semiconducting material that applies amorphous semiconductor.

Note that the solar battery 13 may be a thin-film solar battery that is formed directly on the inner face of the first plate-like member 11. In this case, a configuration is such that the second laminated pressure-bonded resin film 14s (the translucent sealing resin portion 14) and the second plate-like member 12 are arranged facing the first plate-like member 11 and the solar battery 13.

Terminal electrodes 13t are formed at the ends of the solar battery cells 13c and connected to the internal connection wires 16. The solar battery cell array 13ca is configured by connecting the solar battery cells 13c arranged in an array by the internal connection wires 16. The lead wires 17 are configured as extensions of the internal connection wires 16 and taken out through the lead-wire lead-out holes 12h. The internal connection wires 16 and the lead wires 17 are formed by, for example, being solder plated with a thin copper plate.

The solar battery module 1 is approximately rectangular in plan view. The first plate-like member 11 and the second plate-like member 12 are of the same shape and are overlaid so that the outer face of the first plate-like member 11 serves as a light-receiving face (surface) for receiving sunlight. Accordingly, the outer peripheral edge portions of the solar battery module 1 are shaped to be plate-like with no attachments (e.g., terminal boxes as were present in conventional technology), and therefore the solar battery module 1 has compatibility with any mounting structure.

That is, the solar battery module 1 is shaped so as to eliminate the need to arrange members such as a wiring portion (terminal boxes) on its rectangular outer peripheral edge portions. This makes it possible to easily lay out such solar battery modules 1 and to use the daylighting-type solar battery modules 1 in a variety of applications. This also enables the solar battery module 1 to be applied to a gasket structure (see Embodiment 3).

The first plate-like member 11 and the second plate-like member 12 are arranged in parallel facing each other and spaced with a certain interval defined by the solar battery 13 and the translucent sealing resin portion 14. The first plate-like member 11 and the second plate-like member 12 may be made of, for example, soda-lime glass, superwhite glass, figured glass, tempered glass, double tempered glass, or wired glass. The first plate-like member 11 and the second plate-like member 12 do not have to be the same type of plate glass, and different types of plate glasses may be used in combination.

Which type of plate glass to use can be appropriately selected taking into account, for example, surrounding environments where the solar battery module 1 is to be installed. Note that the solar battery module 1 of the present embodiment is configured as a daylighting-type solar battery module 1, and not only the first plate-like member 11 located on the light receiving face side but also the second plate-like member 12 located on the non-light-receiving face side are made of translucent plate glass.

The inside of the solar battery module 1 is filled with the translucent sealing resin portion 14. That is, the translucent sealing resin portion 14 is formed extending into the internal space of the solar battery module 1 (the space sandwiched between the first plate-like member 11 and the second plate-like member 12). In other words, the translucent sealing resin portion 14 extends into even slight gaps formed between the first plate-like member 11 and the solar battery 13 (solar battery cell array 13ca), slight gaps formed between the second plate-like member 12 and the solar battery 13 (solar battery cell array 13ca), and slight gaps formed between the solar battery cells 13c.

The terminal boxes 20 and the diode boxes 21 are provided on the outer side of the second plate-like member 12. The terminal boxes 20 are provided to extract the output of the solar battery 13 arranged inside the solar battery module 1. The diode boxes 21 are provided to house the by-pass diodes connected between the terminal electrodes 13t of the solar battery cells 13c.

The connection cables 24 are provided in the terminal boxes 20. The connection cables 24 are connected to the lead wires 17 inside the terminal boxes 20. The details of the lead wires 17, the connection cables 24, and the terminal boxes 20 will be described later in Embodiment 2.

As described above, with the solar battery module 1 according to the present embodiment, it is possible to align and shape the edge portions of the first plate-like member 11 and the second plate-like member 12. Also, since the terminal boxes 20 and the diode boxes 21 are arranged on the back face side, the external appearance as viewed from the light receiving face can be made into a single plane with no irregularities on the surface, and therefore, it is possible to improve external design.

Furthermore, the outer peripheral edge portions of the solar battery module 1 are shaped like a flat plate with no other members (e.g., the terminal boxes 20) arranged thereon. It is thus possible to maximize the surface area of the solar battery 13 relative to the surface area of the outer peripheral edge portions. This improves the ratio of area utilization and also improves external design.

### Assembly Structure of Solar Battery Module and Procedure for Manufacturing Solar Battery Module

Next is a description of an assembly structure of the solar battery module 1 according to the present embodiment and a procedure for manufacturing the solar battery module 1 (see FIG. 1).

First, the solar battery 13 is formed (solar-battery forming step). The solar battery 13 is a solar battery cell array 13ca formed by connecting multiple solar battery cells 13c. Also, the lead-wire lead-out holes 12h are formed in advance in the second plate-like member 12 (lead-out-hole forming step).

Next, the first laminated pressure-bonded resin film 14f and the second laminated pressure-bonded resin film 14s are arranged symmetrically on both sides of the solar battery 13 (laminate forming step). Furthermore, the first plate-like member 11 and the second plate-like member 12 are arranged symmetrically on the outer sides of the first laminated pressure-bonded resin film 14f and the second laminated pressure-bonded resin film 14s (laminate forming step). That is, a laminate configured by laminating and superimposing the first plate-like member 11, the first laminated pressure-bonded resin film 14f, the solar battery 13, the second laminated pressure-bonded resin film 14s, and the second plate-like member 12 is prepared (laminate forming step).

Note that in the case where the solar battery 13 is a thin-film solar battery that is formed directly on the first plate-like member 11, the first plate-like member 11 and the solar battery 13 are integrated in advance, and therefore the first laminated pressure-bonded resin film 14f is omitted. That is, a laminate configured by the first plate-like member 11 on which the solar battery 13 is formed, the second laminated pressure-bonded resin film 14s, and the second plate-like member 12 is prepared (laminate forming step).

The laminate obtained in the laminate forming step (the first plate-like member 11, the first laminated pressure-bonded resin film 14f, the solar battery 13, the second laminated pressure-bonded resin film 14s, and the second plate-like member 12) is heated in vacuum conditions, and vertical pressure is applied in this state. This forms the translucent sealing resin portion 14 in gaps between the first plate-like member 11 and the second plate-like member 12 (solar-battery laminate forming and sealing step/lamination step/pressure bonding step).

That is, lamination processing is performed by performing, under vacuum conditions, heat and pressure processing on the first plate-like member 11, the first laminated pressure-bonded resin film 14f, the solar battery 13, the second laminated pressure-bonded resin film 14s, and the second plate-like member 12, which have been laminated and superimposed.

Hereinbelow, a further detailed description is given.

First, the first laminated pressure-bonded resin film 14f is laid on the first plate-like member 11, and the solar battery cells 13c arranged in an array are overlaid thereon. The solar battery cell array 13ca (solar battery 13) serving as an electric power generating member (electromotive force circuit) is formed by electrically connecting the solar battery cells 13c by the internal connection wires 16. The solar battery cell array 13ca may be formed before being superimposed on the first laminated pressure-bonded resin film 14f, or may be formed by connecting the internal connection wires 16 after having been arranged on the first laminated pressure-bonded resin film 14f.

Note that the first laminated pressure-bonded resin film 14f may be configured by multiple films. Using multiple films in the configuration improves the accuracy of control of the film thickness.

The lead wires 17 connected to the connection cables 24 in the terminal boxes 20 are formed by bending the internal connection wire 16 upward (toward the lead-wire lead-out holes 12h) at positions where they can be inserted in the lead-wire lead-out holes 12h provided in the second plate-like member 12 (FIGS. 2A, 2B).

In the case of a thin-film solar battery (solar battery 13) that is formed directly on the surface of the first plate-like member 11, the internal connection wires 16 may be appropriately connected to the solar battery 13 and extended so as to form the lead wires 17 appropriately.

Next, the second laminated pressure-bonded resin film 14s is laid over the solar battery 13. The second laminated pressure-bonded resin film 14s has holes or slits formed at positions where the lead wires 17 can be inserted in the lead-wire lead-out holes 12h. That is, the lead wires 17 pass through the second laminated pressure-bonded resin film 14s and are led out of the lead-wire lead-out holes 12h.

Note that the second laminated pressure-bonded resin film 14s may be configured by multiple films. Using multiple films in the configuration of the second laminated pressure-bonded resin film 14s further improves the accuracy of control of the film thickness.

Then, the second plate-like member 12 is laid over the second laminated pressure-bonded resin film 14s. At this time, the lead wires 17 pass through the lead-wire lead-out holes 12h provided in the second plate-like member 12 and are extracted out of the second plate-like member 12.

Furthermore, the lead wires 17 are bent at the bent portions 17b in preparation for the lamination step. This causes the lead wires 17 to be arranged along the second plate-like member 12. Note that, as described above, the adhesion prevention member 18f made of, for example, a fluorine-based resin film is inserted between the bent lead wires 17 and the second plate-like member 12 in order to prevent adhesion between the lead wires 17 and the second plate-like member 12 due to part of the resin of the translucent sealing resin portion 14 having leaked from the lead-wire lead-out holes 12h provided in the second plate-like member 12 in the lamination step (sealing step).

Furthermore, the lead-wire lead-out holes 12h are covered with the outflow-resin molding member 18s having air permeability in order to suppress leakage of part of the resin of the translucent sealing resin portion 14 from the lead-wire lead-out holes 12h in the second plate-like member 12 and mold the resin in the same plane as the outer face 12s of the second plate-like member 12. The air permeability of the outflow-resin molding member 18s prevents air bubbles from being trapped and improves formability and reliability.

After the laminate (the first plate-like member 11, the first laminated pressure-bonded resin film 14f, the solar battery 13, the second laminated pressure-bonded resin film 14s, and the second plate-like member 12) has been formed, welding processing is performed, by application of heat and pressure, on the first laminated pressure-bonded resin film 14f and the second laminated pressure-bonded resin film 14s. The first plate-like member 11 and the second plate-like member 12 are thereby thermally welded together (lamination step/sealing step).

By the application of heat and pressure in the lamination step (sealing step), the first laminated pressure-bonded resin film 14f and the second laminated pressure-bonded resin film 14s melt and flow to fill in the spaces between the first plate-like member 11 and the second plate-like member 12 without gaps. The melted first laminated pressure-bonded resin film 14f and second laminated pressure-bonded resin film 14s are thereafter hardened in a crosslinking reaction, thus forming the translucent sealing resin portion 14.

As described above, the translucent sealing resin portion 14 is formed between the first plate-like member 11 and the second plate-like member 12 through the laminate forming step, the lamination step, and the sealing step. Also, the solar battery cell array 13ca (solar battery 13) is sealed with the translucent sealing resin portion 14. Note that it is necessary to appropriately select the type and film thickness of the first laminated pressure-bonded resin film 14f and the second laminated pressure-bonded resin film 14s, the conditions under which heat and pressure are applied, and the like so that the translucent sealing resin portion 14 is formed extending into the lead-wire lead-out holes 12h.

The solar battery module 1 according to the present embodiment employs the manufacturing steps including first sequentially laminating and superimposing the first plate-like member 11, the first laminated pressure-bonded resin film 14f, the solar battery 13, the second laminated pressure-bonded resin film 14s, and the second plate-like member 12 in the order specified, and then applying heat and pressure to the first laminated pressure-bonded resin film 14f and the second laminated pressure-bonded resin film 14s so as to form the translucent sealing resin portion 14.

However, it is sufficient that the completed shape (the shape obtained after the sealing step) has the structure shown in FIG. 2B, and for example, the order of the lamination and superimposition may be reversed, i.e., the manufacturing steps may include first laminating and superimposing the second plate-like member 12, the second laminated pressure-bonded resin film 14s, the solar battery 13, the first laminated pressure-bonded resin film 14f, and the first plate-like member 11 in the order specified and then applying heat and pressure to the first laminated pressure-bonded resin film 14f and the second laminated pressure-bonded resin film 14s so as to form the translucent sealing resin portion 14.

The terminal boxes 20 are arranged and attached so as to cover the lead-wire lead-out holes 12h in the back face (second plate-like member 12) of the solar battery module 1 formed through the laminate forming step, the lamination step, and the sealing step. Also, the diode boxes 21 are arranged and attached so as to cover the lead-wire lead-out holes 12h formed in order to connect the by-pass diodes. The solar battery module 1 according to the present embodiment is thereby manufactured.

Note that the terminal boxes 20 and the diode boxes 21 are separately arranged in the solar battery module 1 according to the present embodiment, but they may be formed into common casings. For example, the by-pass diodes arranged and connected inside the diode boxes 21 may be arranged and connected inside the terminal boxes 20.

### Method for Manufacturing Solar Battery Module

A method for manufacturing the solar battery module 1 according to the present embodiment is as follows.

That is, the method for manufacturing the solar battery module 1 according to the present embodiment is a method for manufacturing the solar battery module 1 that includes the first plate-like member 11 having translucency and serving as a light receiving face, the solar battery 13, the second plate-like member 12 having translucency and equipped with the lead-wire lead-out holes 12h through which the lead wires 17 connected to the solar battery 13 are led out, and the translucent sealing resin portion 14 formed between the first plate-like member 11 and the second plate-like member 12 and for sealing the solar battery 13.

The method for manufacturing the solar battery module 1 according to the present embodiment aims to manufacture, with excellent productivity, a daylighting-type solar battery module 1 that has compatibility with a construction method that requires the solar battery module 1 to have shaped edge portions at the time of installation

The method for manufacturing the solar battery module 1 according to the present embodiment includes a lead-out-hole forming step of forming the lead-wire lead-out holes 12h in the second plate-like member 12, a laminate forming step of laminating the first plate-like member 11, the first laminated pressure-bonded resin film 14f, the solar battery 13, the second laminated pressure-bonded resin film 14s, and the second plate-like member 12 so as to form a laminate, and a solar-battery laminate forming and sealing step of forming the translucent sealing resin portion 14 between the first plate-like member 11 and the second plate-like member 12 by the application of heat and pressure to the laminate, and sealing the solar battery 13.

With this configuration, the edge portions of the first plate-like member 11 and the second plate-like member 12 (edge portions of the solar battery module 1) can be shaped to be plate-like, and therefore it is possible to manufacture, with excellent productivity, the daylighting-type solar battery module 1 that has compatibility with a construction method that requires the module to have shaped edge portions at the time of installation.

### Example 1-1: In the Case of Thin-Film Solar Battery

Next is a description of a first example of the method for manufacturing a solar battery module with reference to FIG. 4. FIG. 4 shows an example in which the solar battery is a thin-film solar battery that is formed directly on the first plate-like member.

In the present example, a light-receiving glass plate that corresponds to the first plate-like member and a back glass plate that corresponds to the second plate-like member have the following dimensions:
Light-receiving glass plate (first plate-like member): 1000 mm × 1200 mm, a thickness of 6 mm, and
Back glass plate (second plate-like member): 1000 mm × 1200 mm, a thickness of 8 mm.
First, in the manufacture of a solar battery module 1A, a solar battery is formed on the light-receiving glass plate (11) (solar-battery forming step).

That is, the solar battery (13) is formed by laminating microcrystalline silicon on the light-receiving glass plate (11). Furthermore, lead-wire lead-out holes are formed in the back glass plate (12) (lead-out-hole forming step). The lead-wire lead-out holes (12h) are formed by making four circular through holes with a diameter of 10 mm in the back glass plate (12).

Next, internal connection wires (16) are connected to the solar battery. The internal connection wires are then bent so as to be aligned with the lead-wire lead-out holes (12h) of the back glass plate. The internal connection wires are solder plated copper wires having a width of 6 mm and a thickness of 0.3 mm and coated with an insulating resin such as PET.

Next, a second laminated pressure-bonded resin film and the back glass plate (12) are laminated in order on the surface of the light-receiving glass plate (11) on the side that the solar battery has been formed (laminate forming step). In this case, the light-receiving glass plate serving as the first plate-like member and the solar battery are integrated in advance. Thus, a first laminated pressure-bonded resin film is omitted. That is, a laminate is configured by the light-receiving glass plate (11) on which the solar battery has been formed, the second laminated pressure-bonded resin film, and the back glass plate (12).

The second laminated pressure-bonded resin film is sheet-form EVA. This sheet-form EVA film has cuts formed in advance. The internal connection wires are led out of the back glass plate through the cuts of the sheet-form EVA and the lead-wire lead-out holes of the back glass plate, thus forming lead wires.

Then, the lead wires that have been led out to the outer face of the back glass plate (12) through the respective lead-wire lead-out holes (12h) are bent along the surface of the back glass plate.

Then, the lead-wire lead-out holes of the back glass plate through which the lead wires are led out are blocked with an outflow-resin molding member made of cotton fabric. The air permeability of the cotton fabric prevents air bubbles from being trapped, and improves formability and reliability. Furthermore, a plate-like adhesion prevention member made of a fluorine-based resin material such as polytetrafluoroethylene is provided between the bent lead wires and the back glass plate. This prevents adhesion between the lead wires and the back glass plate.

Following this, heat and pressure processing is performed on the laminate of the light-receiving glass plate on which the solar battery has been formed, the second laminated pressure-bonded resin film (sheet-form EVA), and the back glass plate (lamination step). This causes the EVA to melt and flow between the light-receiving glass plate and the back glass plate. The melted EVA is further hardened in a subsequent crosslinking reaction and seals the solar battery between the light-receiving glass plate and the back glass plate, thus forming the translucent sealing resin portion (solar-battery laminate forming and sealing step/pressure bonding step).

Thereafter, the outflow-resin molding member and the adhesion prevention member used are removed from the outer face of the back glass plate.

Then, two terminal boxes (20) are arranged so as to cover the lead-wire lead-out holes of the back glass plate (12). The terminal boxes are made of a polyphenylene oxide (PPO) resin and each have an opening of 40 mm × 30 mm in the bottom face. The lead wires that are led out through the lead-wire lead-out holes of the back glass plate are pulled inside the terminal boxes through the openings of the terminal boxes.

Then, the bottom faces of the terminal boxes (20) are bonded to the back glass plate (12). The lead wires pulled inside the terminal boxes are connected to cable terminals extended from connection cables. Note that diodes are connected between the cable terminals.

Finally, the inside of the terminal boxes (20) is filled and sealed with a silicone resin.

The solar battery module 1A as shown in FIG. 4 is thereby obtained. The peripheral edge portions of the solar battery module 1A are shaped to be plate-like, and therefore it is possible to manufacture a daylighting-type solar battery module that has compatibility with a construction method that requires the module to to have shaped edge portions at the time of installation.

### Example 1-2: In the case of Crystalline Silicon Solar Battery

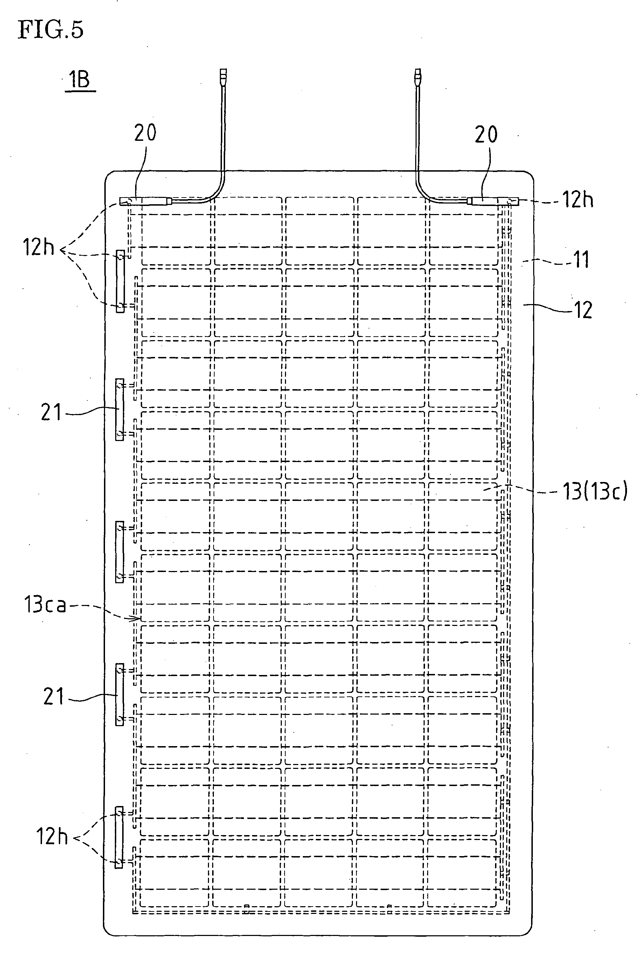

Next is a description of a second example of the method for manufacturing a solar battery module with reference to FIG. 5. FIG. 5 shows an example in which the solar battery is a crystalline silicon solar battery.

In the present example, a light-receiving glass plate that corresponds to the first plate-like member and a back glass plate that corresponds to the second plate-like member have the following dimensions:
Light-receiving glass plate (first plate-like member): 1000 mm × 1800 mm, a thickness of 8 mm, and
Back glass plate (second plate-like member): 1000 mm × 1800 mm, a thickness of 10 mm.
First, in the manufacture of a solar battery module 1B, a solar battery is formed (solar-battery forming step). The solar battery (13) is made of polycrystalline silicon and forms a solar battery string with 10 solar battery cells (13c) of an approximately square shape, each side measuring 156 mm, connected in series in an approximately U shape. In the illustrated example, five such solar battery strings are formed.

Next, lead-wire lead-out holes (12h) are formed in the back glass plate (12) (lead-out-hole forming step). The lead-wire lead-out holes are formed by making 12 circular through holes with a diameter of 10 mm in the back glass plate.

Then, the solar battery strings are connected so as to form a solar battery cell array (13ca). Specifically, the lead wires led out from the ends of all of the solar battery strings are connected using solder plated copper wires having a width of 6 mm and a thickness of 0.3 mm, in order to connect the solar battery strings. Furthermore, the lead wires are bent so as to be aligned with the lead-wire lead-out holes (12h) of the back glass plate (12).

Then, a laminate is prepared by laminating sheet-form EVA (a first laminated pressure-bonded resin film), the solar battery cell array (13ca), sheet-form EVA (a second laminated pressure-bonded resin film), and the back glass plate (12) in order on the light-receiving glass plate (11) (laminate forming step). The sheet-form EVA has cuts formed in advance. The internal connection wires are led out of the back glass plate through the cuts of the sheet-form EVA and the lead-wire lead-out holes of the back glass plate, thus forming the lead wires.

Then, the lead wires led out to the outer face of the back glass plate (12) through the lead-wire lead-out hole (12h) are bent along the surface of the back glass plate.

Then, the lead-wire lead-out holes of the back glass plate through which the lead wires are led out are blocked with an outflow-resin molding member made of cotton fabric. The air permeability of the cotton fabric prevents air bubbles from being trapped and improves formability and reliability. Furthermore, a plate-like adhesion prevention member made of a fluorine-based resin material such as polytetrafluoroethylene is provided between the lead wires and the back glass plate. This prevents adhesion between the lead wires and the back glass plate.

Following this, heat and pressure processing is performed under a vacuum environment on the laminate configured by the light-receiving glass plate, the sheet-form EVA, the solar battery cell array, the sheet-form EVA, and the back glass plate (lamination step). This causes the EVA to melt and flow between the light-receiving glass plate (11) and the back glass plate (12). The melted EVA is further hardened in a subsequent crosslinking reaction and seals the solar battery between the light-receiving glass plate and the back glass plate, thus forming the translucent sealing resin portion (solar-battery laminate forming and sealing step/pressure bonding step).

Thereafter, the outflow-resin molding member and the adhesion prevention member used are removed from the outer face of the back glass plate.

Then, terminal boxes (20) and diode boxes (21) are arranged so as to cover the respective lead-wire lead-out holes (12h) of the back glass plate (12). The terminal boxes and the diode boxes are made of a polyphenylene oxide (PPO) resin and each have an opening of 16 mm × 2 mm in the bottom face. Furthermore, the lead wires led out through the respective lead-wire lead-out holes (12h) of the back glass plate (12) are pulled inside the terminal boxes (20) and the diode boxes (21) through the respective openings of the boxes.

Then, the bottom faces of the terminal boxes (20) and the diode boxes (21) are bonded and attached to the back glass plate (12). The lead wires pulled inside the terminal boxes are connected to cable terminals extended from connection cables. Also, the lead wires pulled inside the diode boxes are connected to diodes.

Finally, the inside of the terminal boxes and the diode boxes is filled and sealed with a silicone resin.

The solar battery module 1B is thereby obtained. The peripheral edge portions of the solar battery module 1B are shaped to be plate-like, and therefore it is possible to manufacture a daylighting-type solar battery module that has compatibility with a construction method that requires the module to to have shaped edge portions at the time of installation.

### Embodiment 2

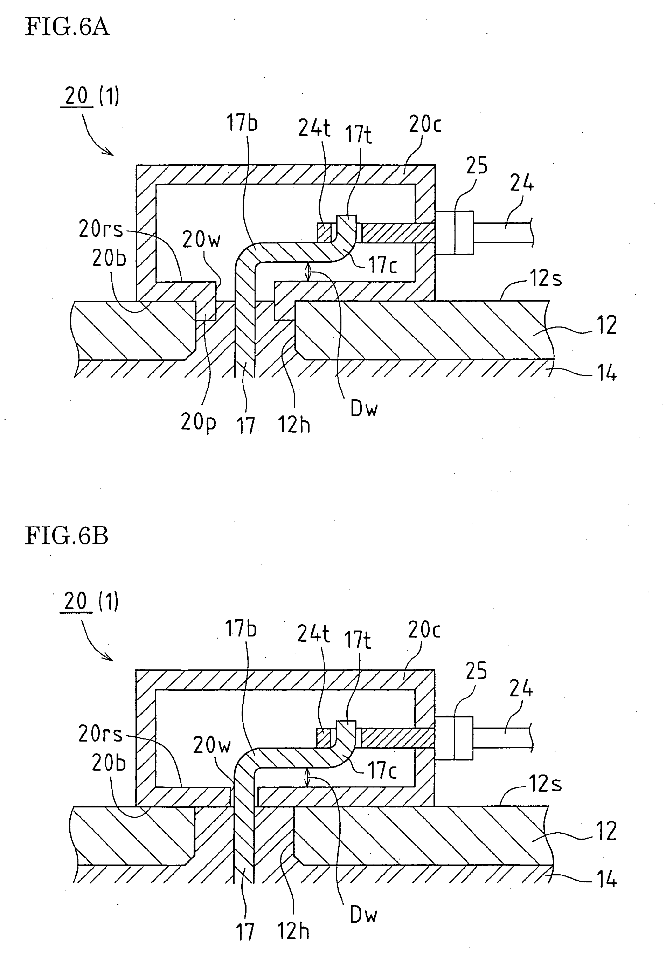

Below is a description of the terminal boxes applied to a solar battery module according to the present embodiment, and the arrangement or the like of the lead wires, the bent portions, and the wire terminals provided inside the terminal boxes with reference to FIGS. 6A through 6E. Note that the basic configuration of the solar battery module according to the present embodiment is similar to that of the solar battery module 1 according to Embodiment 1, and therefore, the following description mainly focuses on aspects that are different from those described above, citing the reference numerals used in the above description where appropriate in order to avoid redundant descriptions.

FIG. 6A is a partial cross-sectional view conceptually illustrating an example of the arrangement of a terminal box in a solar battery module according to Embodiment 2 of the present invention (Example 2-1). FIG. 6B is a partial cross-sectional view conceptually illustrating an example of the arrangement of a terminal box in the solar battery module according to Embodiment 2 of the present invention (Example 2-2).

The terminal boxes 20 according to the examples shown in FIGS. 6A and 6B (Examples 2-1 and 2-2) are arranged so as to cover lead-wire lead-out holes 12h. Each terminal box 20 houses a lead wire 17 (a wire terminal 17t) and a cable terminal 24t extended from a connection cable 24 inside a casing 20c so as to ensure electrical insulation, safety, and reliability. A bottom face 20b of the terminal box 20 is bonded to the second plate-like member 12. Note that an opening 20w of the bottom face 20b and a lead-wire lead-out hole 12h are aligned with each other.

The lead wire 17 extended from an internal connection wire 16 is bent at a portion that is led out of the lead-wire lead-out hole 12h. Examples of the bent portion are bent portions 17b and 17c. Of the bent portions, for example, the bent portion 17b is located above the lead-wire lead-out hole 12h and formed in a portion with an interval Dw from an inner side face 20rs. Accordingly, the cable terminal 24t of the connection cable 24 and the wire terminal 17t (of the lead wire 17) can be easily connected to each other. Ordinarily, the wire terminal 17t and the cable terminal 24t are soldered to each other.

Also, inside the casing 20c of the terminal box 20 is provided the cable terminal 24t connected to the connection cable 24. The cable terminal 24t is connected to the connection cable 24 through a water-proof connector 25 attached to the outside of the casing 20c of the terminal box 20.

Connecting the wire terminal 17t and the cable terminal 24t inside the terminal box 20 (casing 20c) and connecting the cable terminal 24t and the connection cable 24 via the water-proof connector 25 provided outside the casing 20c improves ease of maintenance. Note that an ordinary connector may be employed instead of the water-proof connector 25.

With the solar battery module 1 according to the present embodiment, each terminal box 20 (Examples 2-1 and 2-2) has the bottom face 20b with an opening 20w corresponding to a lead-wire lead-out hole 12h. The bottom face 20b is bonded to the second plate-like member 12. Accordingly, the lead-wire lead-out hole 12h can be blocked from the outside. This prevents moisture from entering from the outside into the solar battery module 1 through the lead-wire lead-out hole 12h and improves reliability.

Furthermore, since the bottom face 20b of the terminal box 20 is bonded to the second plate-like member 12 (the outer face 12s of the second plate-like member 12), it is possible to prevent the physical strength of the second plate-like member 12 from being reduced due to the formation of the lead-wire lead-out hole 12h, and rather to improve that physical strength. The casing 20c of the terminal box 20 may be made of lightweight metal such as aluminum, a synthetic resin that has excellent mechanical strength, or the like. Note that if a lid (not shown) that is openable and closable from the outside is provided in the terminal box 20, it becomes easy to connect the lead wire 17 (wire terminal 17t) and the connection cable 24 (cable terminal 24t) after the terminal box 20 is bonded to the second plate-like member 12.

### Example 2-1

With a terminal box 20 according to Example 2-1 shown in FIG. 6A, the opening 20w is provided with a projecting portion 20p that is aligned with the lead-wire lead-out hole 12h. Accordingly, it is possible to align the terminal box 20 with the lead-wire lead-out hole 12h with ease and high precision, thus making a solar battery module 1 having high productivity. Note that the projecting portion 20p may, for example, have a pin shape since it is sufficient that it can be used for positioning.

Furthermore, since the terminal box 20 can be aligned with the lead-wire lead-out hole 12h with ease and high precision, it is also possible to easily fit the wire terminal 17t at the tip portion of the lead wire 17 to the cable terminal 24t provided in the connecting location of the connection cable 24 with high accuracy.

In FIG. 6A, the internal connection wire 16 is bent in the vicinity of the lead-wire lead-out hole 12h and led out as a lead wire 17 along the shape of the lead-wire lead-out hole 12h (the shape of the end face of the opening).

Furthermore, the interval Dw between the lead wire 17 and the inner side face 20rs of the terminal box 20 on the second plate-like member 12 side is set to be greater than the amount by which the projecting portion 20p projects. Accordingly, mechanical stress applied when aligning the terminal box 20 with the lead-wire lead-out hole 12h or mechanical stress applied when connecting the wire terminal 17t at the tip portion of the lead wire 17 and the connection cable 24 is not likely to be applied to the lead wire 17 in the vicinity of the lead-wire lead-out hole 12h.

Also, since the lead wire 17 has a bent portion 17b in a portion that is led out of the lead-wire lead-out hole 12h of the second plate-like member 12 and is spaced from surrounding members such as the terminal box 20 so as to not contact therewith, the wire terminal 17t of the lead wire 17 and the cable terminal 24t of the connection cable 24 are connected with elasticity when the terminal box 20 is arranged. That is, mechanical stress is less likely to be applied to the lead wire 17 in the vicinity of the lead-wire lead-out hole 12h.

In the case where the lead wire 17 is led out along the shape of the lead-wire lead-out hole 12h (the shape of the end face of the opening), there are unlikely to be any gaps at the interface between the translucent sealing resin portion 14 and the lead wire 17 that is led out of the lead-wire lead-out hole 12h filled with the translucent sealing resin portion 14. Accordingly, even if moisture entering from the outside of the terminal box 20 reaches in the vicinity of the opening 20w, it is possible to suppress the entry of moisture into the solar battery module 1.

Furthermore, the lead wire 17 has a bent portion 17b in a portion that is led out of the lead-wire lead-out hole 12h of the second plate-like member 12 and is not in contact with surrounding members such as the terminal box 20.

Accordingly, a configuration is possible in which heat generated by connecting the wire terminal 17t of the lead wire 17 and the cable terminal 24t of the connection cable 24 is not likely to be transmitted to the second plate-like member 12 side, and therefore, thermal stress in the vicinity of the lead-wire lead-out hole 12h can be reduced.

In particular, if the configuration is applied to diode boxes 21 including heating devices such as diodes, thermal stress can be effectively reduced.

Furthermore, since mechanical stress applied when aligning the terminal box 20 with the lead-wire lead-out hole 12h or mechanical stress applied when connecting the wire terminal 17t at the tip portion of the lead wire 17 and the connection cable 24 is not likely to be applied to the lead wire 17 in the vicinity of the lead-wire lead-out hole 12h, it is possible to manufacture a solar battery module by automated production equipment and to thereby improve productivity and reliability.

Furthermore, although not shown, the terminal boxes 20 can be partially or completely filled and sealed with a sealing resin such as a silicone resin after the wire terminal 17t and the connection cable 24 are connected. Such sealing with a sealing resin further suppresses the entry of moisture into the solar battery module 1.

Furthermore, it is preferable to use a holding member for holding the bent portion 17b in the lamination step and the sealing step. The use of a holding member prevents the lead wire 17 and the bent portion 17b from being deformed in a way not anticipated, due to the bonding pressure applied during lamination. Alternatively, the bent portion 17b or the bent portion17c (wire terminal 17t) may be formed in accordance with the shape of the holding member, using the bonding pressure applied during lamination.

This allows the bent portion 17b or the wire terminal 17t (bent portion17c) to be formed such that its position and shape are adjusted relative to the lead-wire lead-out hole 12h of the second plate-like member 12, and makes it easy to connect the lead wire 17 and the connection cable 24 while suppressing misalignment of the bent portion 17b or the wire terminal 17t due to variations in the lead wire 17 or variations in assembly.

A configuration is also possible in which the holding member serves as both the outflow-resin molding member 18s and the adhesion prevention member 18f.

### Example 2-2

With a terminal box 20 in Example 2-2 shown in FIG. 6B, the opening 20w has a slit shape corresponding to a lead wire 17. Accordingly, it is possible to position the lead wire 17 that is led out of the lead-wire lead-out hole 12h and the terminal box 20 with high precision while suppressing gaps around the lead wire 17, and to suppress the entry of moisture into the solar battery module 1. This improves productivity and reliability.

Since the terminal box 20 can be aligned with the lead wire 17 with ease and high precision, it is possible to easily fit the wire terminal 17t at the tip portion of the lead wire 17 to the cable terminal 24t provided in the connecting location of the connection cable 24 with high precision.

In FIG. 6B, the internal connection wire 16 is bent in the vicinity of the lead-wire lead-out hole 12h and led out as a lead wire 17 along the shape of the lead-wire lead-out hole 12h (the shape of the end face of the opening).

Furthermore, the lead wire 17 and the inner side face 20rs of the terminal box 20 on the second plate-like member 12 side are spaced with an interval Dw. Accordingly, mechanical stress applied when aligning the terminal box 20 with the lead-wire lead-out hole 12h or mechanical stress applied when connecting the wire terminal 17t at the tip portion of the lead wire 17 and the connection cable 24 is not likely to be applied to the lead wire 17 in the vicinity of the lead-wire lead-out hole 12h.

Furthermore, since the lead wire 17 has a bent portion 17b in a portion that is led out of the lead-wire lead-out hole 12h of the second plate-like member 12, and is spaced from surrounding members such as the terminal box 20 without contact, the wire terminal 17t of the lead wire 17 and the cable terminal 24t of the connection cable 24 are connected with elasticity when the terminal box 20 is arranged. That is, the mechanical stress is less likely to be applied to the lead wire 17 in the vicinity of the lead-wire lead-out hole 12h.

There is hardly any gap at the interface between the translucent sealing resin portion 14 and the lead wire 17 that is led out through the slit opening 20w from the lead-wire lead-out hole 12h that is filled with the translucent sealing resin portion 14. Accordingly, even if moisture entering from the outside of the terminal box 20 reaches in the vicinity of the opening 20w, it is possible to suppress the entry of moisture into the solar battery module 1.

Furthermore, the lead wire 17 has a bent portion 17b in a portion that is led out of the lead-wire lead-out hole 12h of the second plate-like member 12, and is not in contact with surrounding members such as the terminal box 20.

Accordingly, a configuration is possible in which heat generated by connecting the wire terminal 17t of the lead wire 17 and the cable terminal 24t of the connection cable 24 is not likely to be transmitted to the second plate-like member 12 side, and therefore, thermal stress in the vicinity of the lead-wire lead-out hole 12h can be reduced.

In particular, if the configuration is applied to the diode boxes 21 including heating devices such as diodes, thermal stress can be effectively reduced.

Furthermore, since mechanical stress applied when aligning the terminal box 20 with the lead-wire lead-out hole 12h or mechanical stress applied when connecting the wire terminal 17t at the tip portion of the lead wire 17 and the connection cable 24 is not likely to be applied to the lead wire 17 in the vicinity of the lead-wire lead-out hole 12h, it is possible to manufacture a solar battery module by automated production equipment and to thereby improve productivity and reliability.

Furthermore, although not shown, the terminal box 20 can be partially or completely filled and sealed with a sealing resin such as a silicone resin after the wire terminal 17t and the connection cable 24 are connected. Such sealing with a sealing resin further suppresses the entry of moisture into the solar battery module 1.

Furthermore, it is preferable to use a holding member for holding the bent portion 17b in the laminate forming step and the sealing step. The use of a holding member prevents the lead wire 17 or the bent portion 17b from being deformed in a way not anticipated due to the bonding pressure applied during lamination. Alternatively, the bent portion 17b or the bent portion17c (wire terminal 17t) may be formed in accordance with the shape of the holding member, using the bonding pressure applied during lamination.

This allows the bent portion 17b or the wire terminal 17t (bent portion17c) to be formed such that its position and shape are adjusted relative to the lead-wire lead-out hole 12h of the second plate-like member 12, thus making it easy to connect the lead wire 17 and the connection cable 24 while suppressing misalignment of the bent portion 17b or the wire terminal 17t due to variations in the lead wire 17 or variations in assembly.

A configuration is also possible in which the holding member serves as both the outflow-resin molding member 18s and the adhesion prevention member 18f.

Note that the lead wire 17 has a bent portion 17b in the configurations of Examples 2-1 and 2-2, but in the case where the cable terminal 24t of the connection cable 24 is located immediately above the lead-wire lead-out hole 12h or the opening 20w, the lead wire 17 does not need to have the bent portion 17b.

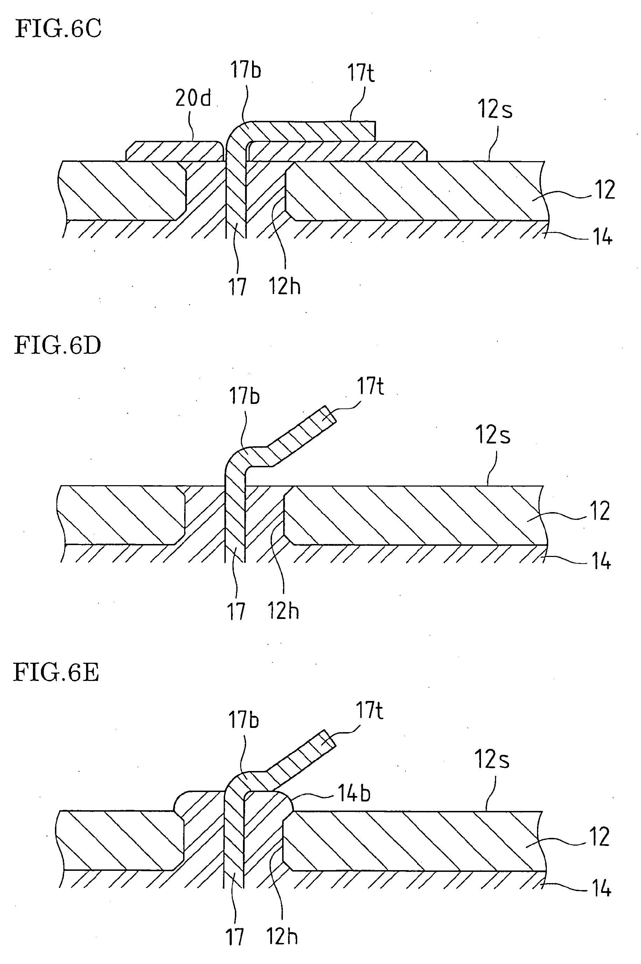

The arrangement of the lead wires, the bent portions, and the wire terminal is further described with reference to FIGS. 6C to 6E.

### Example 2-3

FIG. 6C is a partial cross-sectional view conceptually illustrating a state in which a lead wire is arranged in a terminal box of the solar battery module according to Embodiment 2 of the present invention (Example 2-3).

A lead wire 17 in Example 2-3 has a bent portion 17b bent along a foundation member 20d. The foundation member 20d, which is arranged so as to block the lead-wire lead-out hole 12h of the second plate-like member 12, may, for example, be fixed in advance in the laminate forming step. Also, the bent portion 17b may be formed along the foundation member 20d using the bonding pressure applied in the direction of lamination in the lamination step.

That is, the foundation member 20d can act as the holding member described in Examples 2-1 and 2-2. Note that it is possible to apply the foundation member 20d in place of the outflow-resin molding member 18s or the adhesion prevention member 18f.

### Example 2-4

FIG. 6D is a partial cross-sectional view conceptually illustrating a state in which a lead wire is arranged in a terminal box of the solar battery module according to Embodiment 2 of the present invention (Example 2-4).

After the outflow-resin molding member 18s or the adhesion prevention member 18f is removed after the lamination step, the tip portion of the lead wire 17 may be raised so as to elevate the wire terminal 17t at an angle. In this case, it is preferable that the tip portion of the lead wire 17 be raised while faxing the bent portion 17b in order to not transmit mechanical stress from the bent portion 17b to the internal connection wire 16 side.

### Example 2-5

FIG. 6E is a partial cross-sectional view conceptually illustrating a state in which a lead wire is arranged in a terminal box of the solar battery module according to Embodiment 2 of the present invention (Example 2-5).

In the case where the translucent sealing resin portion 14 passes through the outflow-resin molding member 18s (or the adhesion prevention member 18f) and forms a raised sealing resin portion 14b in the lamination step, and the sealing resin portion is in close contact with the lead wire 17, it is preferable that the tip portion of the lead wire 17 is raised so as to elevate the wire terminal 17t at an angle outside the wire lead-out hole 12h, in order not to break the contact between the raised sealing resin portion 14b and the lead wire 17.

In such a case, the bent portion 17b and a vicinity thereof are sterically held owing to the elasticity provided by the raised sealing resin portion 14b, and therefore, mechanical stress is not likely to be transmitted to the lead wire 17 in the vicinity of the lead-wire lead-out hole 12h.

### Embodiment 3

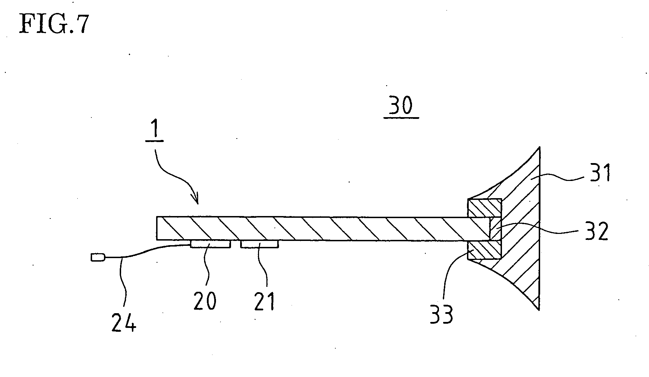

Now, a gasket type solar battery module according to Embodiment 3 will be described with reference to FIG. 7.

The gasket type solar battery module according to the present embodiment directly applies the solar battery module 1 of Embodiment 1 or 2, and therefore, the following description focuses on different aspects while citing the reference numerals used in the above description.

FIG. 7 is a cross-sectional view conceptually illustrating a cross-section around a gasket material used in the gasket type solar battery module according to Embodiment 3 of the present invention.

A gasket type solar battery module 30 according to the present embodiment enables the solar battery modules 1 of Embodiment 1 or 2 to be applied in construction material applications. That is, the gasket type solar battery module 30 according to the present embodiment aims to fit the solar battery module 1 of Embodiment 1 or 2 into a gasket construction method.

The gasket type solar battery module 30 is configured by coupling a gasket material 31 serving as a sealing material used for fixation in construction applications to the peripheral edge portions of the solar battery module 1. The gasket material 31 is made of, for example, chloroprene rubber.

The peripheral edge portions of the solar battery module 1, which constitutes the gasket type solar battery module 30, are positioned in abutment with a setting block 32 provided in a recessed portion of the gasket material 31 and are brought into close contact with the gasket material 31 by a backup material 33 serving as a sealing material.

The gasket type solar battery module 30 is constituted by the solar battery module 1 that has the terminal boxes 20 arranged on the non-light-receiving face (second plate-like member 12) and has tabular peripheral edge portions (i.e., the peripheral edge portions are shaped like a flat plate), and the gasket material 31 that is coupled to the edge portion of the solar battery module 1.

As shown in Embodiments 1 and 2, the connection cable 24 is connected to the lead wire 17 that is led out of the lead-wire lead-out hole 12h formed in the second plate-like member 12, and the connected portion between the lead wire 17 and the connection cable 24 is covered by the terminal box 20 (see FIGS. 6A and 6B). The terminal box 20 has the bottom face 20b with an opening 20w corresponding to the lead-wire lead-out hole 12h. The bottom face 20b is bonded to the second plate-like member 12.

As described in Embodiments 1 and 2, the peripheral edge portions of the solar battery module 1 are shaped like a flat plate. That is, the peripheral edge portions of the solar battery module 1 have no obstructive members (such as terminal boxes 20 or diode boxes 21) that may hinder the installation of the solar battery module 1 to the gasket material 31. This allows the solar battery module 1 to be coupled to the gasket material 31 with ease and reliability, thus making it possible to configure the gasket type solar battery module 30 with the gasket material 31 used in construction applications.

Therefore, the gasket type solar battery module 30 according to the present embodiment is provided with the gasket material 31, which allows the module to be compatible with a gasket type construction method.

The present invention can be reduced to practice in various other forms without departing from its spirit or essential features. For this reason, the above-described exemplary embodiments are to all intents and purposes merely illustrative and should not be construed as limiting. The scope of the present invention is defined by the claims and is not in any way restricted by the descriptions of the specification. Furthermore, all variations and modifications of the claims within the scope of equivalency fall within the scope of the present invention.

This application claims prior right on the basis of Japanese Patent Application No. 2009-102276 filed in Japan on April 20, 2009, the content of which is hereby incorporated in its entirety by reference herein.

### Industrial Applicability

The present invention is suitably applicable to a daylighting-type solar battery module.

### Description of Reference Numerals

- 1: Solar battery module
- 11: First plate-like member
- 12: Second plate-like member
- 12h: Lead-wire lead-out hole
- 12hc: Chamfered portion
- 13: Solar battery
- 13c: Solar battery cell
- 13ca: Solar battery cell array
- 13t: Terminal electrode
- 14: Translucent sealing resin portion
- 14f: First laminated pressure-bonded resin film
- 14s: Second laminated pressure-bonded resin film
- 16: Internal connection wire
- 17: Lead wire
- 17b: Bent portion
- 17c: Bent portion
- 17m: Insulating coating material
- 17t: Wire terminal
- 18f: Adhesion prevention member
- 18s: Outflow-resin molding member
- 20: Terminal box
- 20b: Bottom face
- 20c: Casing
- 20p: Projecting portion
- 20w: Opening
- 21: Diode box
- 24: Connection cable
- 24t: Cable terminal
- 25: Water-proof connector
- 30: Gasket type solar battery module

## Claims

1. A solar battery module comprising:
a solar battery;
a first plate-like member having translucency and serving as a light receiving face;
a second plate-like member having translucency; and
a translucent sealing resin portion for sealing the solar battery provided between the first plate-like member and the second plate-like member,
wherein the second plate-like member is provided with a lead-wire lead-out hole through which a lead wire connected to the solar battery is led out, and the translucent sealing resin portion is formed extending between the lead wire and the lead-wire lead-out hole.

2. The solar battery module according to claim 1, wherein the first plate-like member and the second plate-like member are made of glass.

3. The solar battery module according to claim 1 or 2, wherein the lead-wire lead-out hole has a chamfered portion or a countersunk portion formed in an edge portion.

4. The solar battery module according to claim 3, wherein the chamfered portion or the countersunk portion is formed on both sides of the second plate-like member.

5. The solar battery module according to one of claims 1 to 4, wherein the translucent sealing resin portion formed in the lead-wire lead-out hole is in the same plane as or projects from a surface of the second plate-like member.

6. The solar battery module according to one of claims 1 to 5, comprising a terminal box having a bottom face with an opening formed corresponding to the lead-wire lead-out hole, the bottom face adhering to the second plate-like member.

7. The solar battery module according to claim 6, wherein the opening has a projecting portion that is aligned with the lead-wire lead-out hole.

8. The solar battery module according to claim 6, wherein the opening has a slit shape corresponding to the lead wire.

9. The solar battery module according to one of claims 1 to 8, wherein the lead wire is bent at a portion where the lead wire is led out of the lead-wire lead-out hole.

10. A method for manufacturing a solar battery module that comprises a solar battery, a first plate-like member having translucency and serving as a light receiving face, a second plate-like member having translucency, and a translucent sealing resin portion provided for sealing the solar battery between the first plate-like member and the second plate-like member,
the method comprising:
a lead-out-hole forming step of connecting a lead wire to the solar battery and forming a lead-wire lead-out hole in the second plate-like member;
a lead-out step of leading the lead wire to an outer face of the second plate-like member through the lead-wire lead-out hole; and
a sealing step of forming the translucent sealing resin portion between the first plate-like member and the second plate-like member and sealing the solar battery.

11. The method for manufacturing a solar battery module according to claim 10, wherein after the lead-out step, an outflow-resin molding member having air permeability and heat resistance is arranged on the second plate-like member so as to block the lead-wire lead-out hole through which the lead wire is led out.

12. The method for manufacturing a solar battery module according to claim 11, wherein the outflow-resin molding member is removed from the second plate-like member after the sealing step.

13. The method for manufacturing a solar battery module according to one of claims 10 to 12, comprising:
a step of bending the lead-out lead wire after the lead-out step so that the lead wire is arranged along the outer face of the second plate-like member; and
a step of arranging an adhesion prevention member between the lead wire and the outer face of the second plate-like member, the adhesion prevention member preventing adhesion between the bent lead wire and the second plate-like member.

14. The method for manufacturing a solar battery module according to claim 13, wherein the adhesion prevention member is removed from the second plate-like member after the sealing step.
